# EUROPÄISCHE PATENTSCHRIFT

(11) **EP 2 870 624 B1**
(45) Veröffentlichungstag und Bekanntmachung des Hinweises auf die Patenterteilung: **06.01.2021**
(21) Anmeldenummer: 13735263.9
(22) Anmeldetag: 09.07.2013
(51) Int. Cl.: H01L 21/673, F27D 7/06, F27B 5/16, F27B 5/06

(54) **VORRICHTUNG UND VERFAHREN ZUM WÄRMEBEHANDELN EINES GEGENSTANDS**
METHOD AND DEVICE FOR HEAT TREATING AN OBJECT
DISPOSITIF ET PROCÉDÉ DE TRAITEMENT THERMIQUE D´UN OBJET

(30) Priorität: 09.07.2012 EP 12175615
(43) Veröffentlichungstag der Anmeldung: 13.05.2015
(73) Patentinhaber: (CNBM) Bengbu Design & Research Institute for Glass Industry Co., Ltd., Bengbu (CN)
(72) Erfinder: FÜRFANGER, Martin, 85643 Steinhöring (DE); JOST, Stefan, 81543 München (DE); PALM, Jörg, 80797München (DE)
(74) Vertreter: Gebauer, Dieter Edmund
(86) Internationale Anmeldenummer: PCT/EP2013/064518
(87) Internationale Veröffentlichungsnummer: WO 2014/009388

(56) Entgegenhaltungen:
- WO-A1-01/80291
- WO-A2-2007/077171
- JP-A- H 045 480
- US-A1- 2003 094 446
- US-A1- 2005 238 476

## Beschreibung

Die Erfindung betrifft eine Vorrichtung und ein Verfahren zum Wärmebehandeln eines Gegenstands, insbesondere eines beschichteten Substrats, sowie die Verwendung einer Trennwand in einem gasdicht verschließbaren Gehäuse einer Vorrichtung zum Wärmebehandeln eines Gegenstands als Diffusionsbarriere.

In mehreren technischen Gebieten ist es üblich, Gegenstände einer Wärmebehandlung unterhalb der Schmelztemperatur ("Tempern") zu unterziehen, um gezielt Einfluss auf die Festkörperstruktur zu nehmen. Ein Beispiel hierfür ist das Tempern von Gusseisen zur Verbesserung der Festigkeit und Zähigkeit durch Ändern seines Gefüges. Bekannt ist auch das Anlassen von Stahl nach dem Härten, bei dem innere Spannungen abgebaut werden, wobei sich die Härte des Stahls verringert. Auch bei Gläsern ist es gängige Praxis, innere Spannungen durch Tempern abzubauen, beispielsweise um die Qualität von optischen Komponenten zu erhöhen.

Eine herausragende Bedeutung hat das Tempern bei der Halbleiterfertigung, insbesondere bei der Herstellung von Dünnschichtsolarzellen mit einem Absorber aus einem Verbindungshalbleiter. Hierbei werden dünne Vorläufer- bzw. Precursorschichten auf ein Substrat aufgebracht und mit einer anschließenden schnellen Wärmebehandlung (RTP = Rapid Thermal Processing) zum Verbindungshalbleiter umgesetzt. Eine solche Vorgehensweise ist beispielsweise in J. Palm et al., "CIS module pilot processing applying concurrent rapid selenization and sulfurization of large area thin film precursors", Thin Solid Films 431-432, S. 414-522 (2003) eingehend beschrieben. Dünnschichtsolarzellen als solche wurden in der Patentliteratur bereits vielfach beschrieben. Lediglich beispielhaft sei diesbezüglich auf die Druckschriften DE 4324318 C1 und EP 2200097 A1 verwiesen.

Allgemein erfolgt das Tempern eines Gegenstands in einem Ofen, der eine Aufheizung des Gegenstands gemäß einem vorgebbaren Temperaturprofil auf bestimmte Temperaturen für bestimmte Zeitdauern ermöglicht. Speziell bei der Herstellung von Verbindungshalbleitern ist es wichtig, dass das Tempern in einer kontrollierten Prozessatmosphäre abläuft. Zu diesem Zweck ist es bekannt, den Prozessraum um das mit den Vorläuferschichten beschichtete Substrat durch eine Prozessbox zu begrenzen. Die Prozessbox ermöglicht, den Partialdruck von leicht flüchtigen Chalkogenkomponenten wie Selen oder Schwefel während der Wärmebehandlung zumindest weitestgehend konstant zu halten. Eine solche Prozessbox ist beispielsweise aus der DE 102008022784 A1 bekannt.

In der großtechnischen Fertigung von Dünnschichtsolarmodulen erfolgt die RTP-Wärmebehandlung von Vorläuferschichten in In-Line-Anlagen, in denen die beschichteten Substrate der Reihe nach verschiedenen Prozesskammern zugeführt werden. Ein solches Verfahren ist beispielsweise aus der EP 0662247 B1 bekannt.

Die US-Patentanmeldung Nr. 2005/0238476 A1 zeigt eine Vorrichtung zum Transportieren eines Substrats in einer kontrollierten Atmosphäre mit einem Gehäuse, das einen evakuierbaren Substratraum für das Substrat und einen Nebenraum umfasst. Substrat- und Nebenraum sind durch eine Trennwand mit Nanoporen voneinander getrennt, wobei die Trennwand eine auf dem Knudsen-Prinzip (Thermoosmose) basierende Mikropumpe bildet. Der Substratraum weist eine Kühlplatte (Dekontaminationsplatte) auf, wobei die Trennwand nicht zwischen Substrat und Kühlplatte angeordnet ist. Vielmehr ist die Kühlplatte stets in gegenüberliegender Position zum Substrat angeordnet. Zudem ist der Nebenraum durch die heizbare Trennwand von dem durch die Kühlplatte gekühlten Gehäuseabschnitt bzw. Substratraum thermisch abgekoppelt. Für den Pumpmechanismus ist eine Heizung erforderlich.

Demgegenüber liegt die Aufgabe der vorliegenden Erfindung darin, die im Stand der Technik bekannten Vorrichtungen und Verfahren zum Wärmebehandeln von Gegenständen in vorteilhafter Weise weiterzubilden. Diese und weitere Aufgaben werden nach dem Vorschlag der Erfindung durch eine Vorrichtung und ein Verfahren zum Wärmebehandeln eines Gegenstands, sowie durch die Verwendung einer Trennwand in einer Vorrichtung zum Wärmebehandeln eines Gegenstands gemäß den nebengeordneten Patentansprüchen gelöst. Bevorzugte Ausführungsformen der Erfindung gehen aus den Merkmalen der Unteransprüche hervor.

Erfindungsgemäß ist eine Vorrichtung zum Wärmebehandeln (Tempern) eines beliebigen Gegenstands unterhalb der Schmelztemperatur gezeigt.

Die Vorrichtung dient beispielsweise zur Wärmebehandlung eines beschichteten Substrats, wobei sich im Sinne der Erfindung der Ausdruck "Substrat" auf einen flächigen Körper bezieht, der über zwei einander entgegen gesetzte Oberflächen verfügt, wobei auf einer der beiden Oberflächen ein typischer Weise eine Mehrzahl Schichten enthaltender Schichtenaufbau aufgebracht ist. Die andere Oberfläche des Substrats ist in der Regel unbeschichtet. Beispielsweise handelt es sich um ein mit den Precursor- bzw. Vorläuferschichten eines Verbindungshalbleiters (z.B. Chalkopyrit-oder Kesteritverbindung) beschichtetes Substrat eines Dünnschichtsolarmoduls, das einer RTP-Wärmebehandlung unterzogen werden muss. Ergänzend sei darauf hingewiesen, dass in Dünnschichtsolarzellen überwiegend Verbindungshalbleiter aus Chalkopyritverbindungen, insbesondere Kupfer-Indium/Gallium-Dischwefel/Diselenid, abgekürzt durch die Formel Cu(In,Ga)(S,Se)₂, oder Kesterit-Verbindungen, insbesondere Kupfer-Zink/Zinn-Dischwefel/Diselenid, abgekürzt durch die Formel Cu₂(Zn,Sn)(S,Se)₄ als Absorber eingesetzt werden.

Die erfindungsgemäße Vorrichtung umfasst ein Gehäuse, vorteilhaft ein gasdicht verschließbares (evakuierbares) Gehäuse, das einen Hohlraum umgrenzt. Für eine Wärmebehandlung des Gegenstands kann die Vorrichtung selbständig heizbar sein und zu diesem Zweck eine interne Heizeinrichtung (z.B. eine elektrische Heizung) zum Heizen des Hohlraums umfassen. Die Vorrichtung ist beispielsweise als Ofen zum Tempern des Gegenstands ausgebildet, ohne dass extern Wärme zugeführt werden muss. Alternativ oder zusätzlich kann die Vorrichtung auch nicht selbständig heizbar sein, aber wenigstens einen Gehäuseabschnitt umfassen, der so ausgebildet ist, dass der Gegenstand durch auf den Gehäuseabschnitt auftreffende elektromagnetische Heizstrahlung wärmebehandelbar ist.

Die Vorrichtung umfasst weiterhin eine Trennwand, die so angeordnet ist, dass der Hohlraum in einen Prozessraum zum Aufnehmen des mit Wärme zu behandelnden Gegenstands und einen Zwischenraum unterteilt ist. Die Trennwand verfügt über eine oder mehrere Öffnungen, die so ausgebildet sind, dass die Trennwand als Barriere für die Diffusion eines durch die Wärmebehandlung des Gegenstands im Prozessraum erzeugten gasförmigen Stoffs aus dem Prozessraum in den Zwischenraum wirkt.

Wesentlich hierbei ist, dass die Trennwand einerseits als Diffusionsbarriere (Dampfbarriere) für einen Gasaustausch zwischen Prozess- und Zwischenraum während der Wärmebehandlung des Gegenstands dient, jedoch vor und nach der Wärmebehandlung einen Gasaustausch zwischen Prozess- und Zwischenraum ermöglicht, so dass ein Abpumpen gasförmiger Stoffe aus dem Prozessraum, Spülen mit einem Spülgas, sowie eine Befüllung mit einem Prozessgas durch die Trennwand hindurch möglich ist. Durch die eine oder mehreren Öffnungen bzw. Durchbrechungen in der Trennwand sind Prozess- und Zwischenraum strömungstechnisch miteinander verbunden. Allgemein können die Öffnungen jede beliebige Form aufweisen, beispielsweise eine Schlitz- oder Rundlochform, und auch randständig angeordnet sein.

Bei einer vorteilhaften Ausgestaltung reicht die Trennwand nicht bis zu einer Gehäusewand, so dass eine Öffnung, insbesondere ein Spalt, zwischen Trennwand und Gehäusewand verbleibt.

Beispielsweise, jedoch nicht zwingend, ist eine kleinste Abmessung, beispielsweise ein Radius oder Durchmesser, einer jeweiligen Öffnung der Trennwand größer als die mittlere freie Weglänge der Gasteilchen im Prozessraum.

Insbesondere kann die Trennwand aus einem porösen Material oder einem mit Röhren (gerade, schräge oder gewinkelte Röhren) versehenen Material bestehen oder ein solches Material umfassen.

Somit wird durch die Trennwand ein Prozessraum zum Wärmebehandeln des Gegenstands gebildet, der durch die Trennwand vom Zwischenraum quasi-gasdicht abgetrennt ist. Im Unterschied zu einem offenen Prozessraum, der einen freien Gasaustausch zwischen Prozessraum und äußerer Umgebung erlaubt, sowie zu einem gasdichten Prozessraum, bei dem ein solcher Gasaustausch zwischen Prozessraum und äußerer Umgebung vollständig unterbunden ist, ist der Gasaustausch zwischen Prozessraum und Zwischenraum durch die Trennwand gehemmt. Diese Dampfbarriere beruht auf der Druckabhängigkeit der freien Weglänge: bei nahezu Normaldruck (700-1000mbar) ist die Diffusion durch die vergleichsweise kleinen Öffnungen gehemmt. Wird der Zwischenraum dagegen auf Drücke im Vorvakuumbereich (10-1000pbar) abgepumpt, ist die freie Weglänge stark erhöht und die Trennwand stellt nur noch eine schwache Diffusionsbarriere für den Gasaustausch dar.

Der Prozessraum kann durch die Trennwand abgepumpt werden und Prozessgas kann nach dem Abpumpen auch in den Prozessraum strömen. Bei der Herstellung von Verbindungshalbleitern kann das Prozessgas beispielsweise reaktive Gase wie H₂S, H₂Se, S-Dampf, Se-Dampf oder H₂ sowie Inertgase wie N₂, He oder Ar enthalten. Insbesondere kann durch die quasigasdichte Trennwand der Partialdruck von leicht flüchtigen Chalkogenkomponenten wie Selen oder Schwefel während der Wärmebehandlung von Vorläuferschichten von Verbindungshalbleitern im Prozessraum zumindest weitestgehend konstant gehalten werden. Die flüchtigen Chalkogenkomponenten entstehen im Prozessraum beispielsweise durch Material, das auf das beschichtete Substrat aufgebracht ist.

Um den Hohlraum abpumpen und mit einem Spül- oder Prozessgas befüllen zu können, kann das vorzugsweise gasdicht verschließbare Gehäuse der Vorrichtung wenigstens eine in den Hohlraum mündende, (beispielsweise durch ein Ventil) verschließbare Gasdurchführung umfassen. Die Gasdurchführung kann zu diesem Zweck insbesondere in den Zwischenraum münden.

Durch die erfindungsgemäße Vorrichtung können somit mehrere Vorteile erreicht werden, wobei hervorzuheben ist, dass die Prozessatmosphäre im Hinblick auf flüchtige Bestandteile, die im Prozessraum entstehen, zumindest weitestgehend konstant gehalten werden kann. Zudem kann der Zwischenraum vor den oftmals korrosiven Gasen bei der Wärmebehandlung von Gegenständen geschützt werden, beispielsweise um darin enthaltende Sensoren keinem übermäßigen Verschleiß auszusetzen. Bei entsprechender Auslegung kann eine Evakuierung des Hohlraums der Vorrichtung schnell und effizient erreicht werden. Dies gilt gleichermaßen für eine Befüllung mit Prozessgas, wobei das Prozessgas kosteneffizient in minimaler Menge einsetzbar ist.

Wie bereits ausgeführt, wird durch die Trennwand eine quasi-gasdichte Unterteilung des Hohlraums in einen Prozess- und Zwischenraum erreicht, wobei die Trennwand zu diesem Zweck mit einer oder mehreren Öffnungen versehen ist. Vorzugsweise ist die Trennwand so ausgebildet, dass während der Wärmebehandlung ein Massenverlust eines durch die Wärmebehandlung des Gegenstands, insbesondere beschichteten Substrats, erzeugten gasförmiges Stoffs aus dem Prozessraum weniger als 50%, vorzugsweise weniger als 20%, stärker bevorzugt weniger als 10%, der während der Wärmebehandlung erzeugten Masse des gasförmigen Stoffs beträgt.

Vorteilhaft ist die Trennwand zu diesem Zweck so ausgebildet, dass ein Flächenverhältnis, gebildet aus einer (gesamten) Öffnungsfläche der einen oder mehreren Öffnungen geteilt durch eine innere Oberfläche (Innenfläche) des Prozessraums, im Bereich von 5 x 10⁻⁵ bis 5 x 10⁻⁴ liegt. Hierdurch kann in vorteilhafter Weise erreicht werden, dass die (gesamte) Öffnungsfläche der einen oder mehreren Öffnungen der Trennwand einerseits hinreichend groß ist, um ein zügiges Evakuieren des Prozessraums sowie eine Befüllung mit Spül- bzw. Prozessgas zu ermöglichen, andererseits hinreichend klein ist, so dass die Trennwand als wirksame Dampf- bzw. Diffusionsbarriere für während der Wärmebehandlung im Prozessraum erzeugte flüchtige Komponenten dient.

Bei einer besonders vorteilhaften Ausgestaltung der erfindungsgemäßen Vorrichtung besteht die Trennwand aus einem Material oder enthält zumindest ein solches Material, das einen solchen Wärmeausdehnungskoeffizienten hat, dass sich eine (gesamte) Öffnungsfläche der einen oder mehreren Öffnungen durch Erwärmen der Trennwand während der Wärmebehandlung des Gegenstands auf maximal 50%, vorzugsweise maximal 30%, stärker bevorzugt maximal 10%, des Ausgangswerts (gesamte Öffnungsfläche vor der Wärmebehandlung) verringert. Vorteilhaft hat dieses Material der Trennwand zu diesem Zweck einen Wärmeausdehnungskoeffizienten von mehr als 5 x 10⁻⁶K⁻¹. Auf diese Weise wird eine temperaturgesteuerte Trennwand geschaffen, bei der einerseits im kälteren Zustand durch eine größere (gesamte) Öffnungsfläche ein besonders effizientes Abpumpen des Prozessraums sowie Befüllen des Prozessraums mit Spül- bzw. Prozessgas, andererseits im wärmeren Zustand während der Wärmebehandlung durch thermische Ausdehnung durch eine kleinere (gesamte) Öffnungsfläche eine besonders wirksame Hemmung der Diffusion von während der Wärmebehandlung erzeugten gasförmigen Stoffen vom Prozessraum in den Zwischenraum erreicht wird. Insbesondere kann die Trennwand so ausgebildet werden, dass während der Wärmebehandlung die (gesamte) Öffnungsfläche zumindest annähernd auf Null reduziert wird, so dass ein Gasaustausch zwischen Prozess- und Zwischenraum während der Wärmebehandlung praktisch vollständig unterbunden wird.

Vorteilhaft besteht das Gehäuse der Vorrichtung aus einem Material oder enthält zumindest ein solches Material, dessen Wärmeausdehnungskoeffizient kleiner als 5 x 10⁻⁶ K⁻¹ ist, beispielsweise Quarzglas.

Bei einer weiteren besonders vorteilhaften Ausgestaltung der erfindungsgemäßen Vorrichtung weist das Gehäuse wenigstens einen mit einer Temperier- bzw. Kühleinrichtung zu dessen Temperierung bzw. aktiven Kühlung gekoppelten (ersten) Gehäuseabschnitt auf, wobei die Trennwand zwischen dem Gegenstand und dem temperierbaren bzw. aktiv kühlbaren Gehäuseabschnitt angeordnet ist. Die Temperierung bzw. Kühlung) wenigstens eines Gehäuseabschnitts der Vorrichtung ermöglicht einen verringerten Verschleiß vakuumfähiger Komponenten während der Wärmebehandlung. Hierbei kann durch die als Diffusions- bzw. Dampfbarriere wirkende Trennwand eine unerwünschte Kondensation von während der Wärmebehandlung entstehenden flüchtigen Komponenten auf dem temperierten (aktiv gekühlten) Gehäuseabschnitt verhindert werden, um so den Verlust an flüchtigen Komponenten in der Prozessatmosphäre zu minimieren und deren Partialdruck in der Prozessatmosphäre zumindest weitestgehend konstant zu halten. Insbesondere kann bei der Herstellung von Verbindungshalbleitern der Verbrauch an flüchtigen Chalkogenelementen minimiert und die Qualität der hergestellten Verbindungshalbleiter verbessert werden. Des Weiteren umfasst das Gehäuse einen oder mehrere nicht temperierbare bzw. kühlbare, d.h. nicht mit der Temperier- bzw. Kühleinrichtung gekoppelte., (zweite) Gehäuseabschnitte, bei welchen es sich insbesondere um jene Gehäuseabschnitte handelt, die eine Wärmebehandlung durch auf den Gehäuseabschnitt auftreffende elektromagnetische Heizstrahlung ermöglichen, also beispielsweise im Strahlungsfeld der Heizstrahler liegen. Die ersten Gehäuseabschnitte sind von den zweiten Gehäuseabschnitten verschieden. Die ersten Gehäuseabschnitte sind an die Kühleinrichtung angeschlossen bzw. anschließbar und können daher gekühlt werden, wohingegen die zweiten Gehäuseabschnitte an die Kühleinrichtung nicht angeschlossen sind und daher nicht gekühlt werden können.

Die temperierbaren bzw. kühlbaren (ersten) Gehäuseabschnitte sind im Vergleich zur Temperatur des Substrats und jener Gehäuseabschnitte, die eine Wärmebehandlung durch auftreffende elektromagnetische Heizstrahlung ermöglichen und beispielsweise im Strahlungsfeld der Heizstrahler liegen, aktiv kühlbar. Die temperierbaren bzw. kühlbaren (ersten) Gehäuseabschnitte können vor, während und/oder nach einer Wärmebehandlung des beschichteten Substrats temperiert (aktiv gekühlt) werden.

Wie hier und im Weiteren verwendet, bezieht sich der Ausdruck "kühlbar" auf eine Temperierung des Gehäuseabschnitts auf eine Temperatur die niedriger ist als die Temperatur des Gegenstands bei der Wärmebehandlung bzw. bei einer nicht selbständig heizbaren Vorrichtung jener Gehäuseabschnitte, die eine Wärmebehandlung des Gegenstands durch auftreffende elektromagnetische Heizstrahlung ermöglichen und im Strahlungsfeld der Heizstrahler liegen. Beispielsweise wird der temperierbare Gehäuseabschnitt auf eine Temperatur im Bereich von 20°C bis 200°C temperiert. Durch diese Temperierung bzw. Kühlung können die in der Vakuumtechnik üblichen Kunststoffdichtungen (Elastomere, Fluorelastomere) und andere vergleichsweise kostengünstige Standardkomponenten zur Vakuumabdichtung der Vorrichtung verwendet werden, die jedoch Temperaturen über 200°C dauerhaft nicht überstehen.

Bei einer weiteren besonders vorteilhaften Ausgestaltung der erfindungsgemäßen Vorrichtung umfasst der Hohlraum bei der Wärmebehandlung des Gegenstands eine wärmere Zone und wenigstens eine kältere Zone, wobei die Trennwand zwischen der wärmeren Zone und der wenigstens einen kälteren Zone angeordnet ist, um die wärmere Zone von der wenigstens einen kälteren Zone zu trennen. Beispielsweise ist die Vorrichtung in Form eines Zonenofens ausgebildet, der über eine wärmere bzw. heißeste Kernzone verfügt, die als Prozessbereich zum Prozessieren eines Gegenstands dient, welche von kälteren Randzonen umgeben ist. Die Kernzone ist durch die Trennwand von den beiden Randzonen getrennt, d.h. die Trennwand ist zwischen Kern- und Randzonen angeordnet. Durch die Trennwand kann in vorteilhafter Weise eine unerwünschte Kondensation von während der Wärmebehandlung in der Kernzone entstehenden flüchtigen Komponenten auf den Wandabschnitten der kälteren Randzonen verhindert werden.

Die erfindungsgemäße Vorrichtung umfasst beispielsweise ein Gehäuse mit einem beispielweise einteiligen Gehäuseabschnitt und einer Gehäuseöffnung zum Einbringen des Gegenstands in den Prozessraum bzw. Entnehmen des Gegenstands aus dem Prozessraum, sowie einem Verschlussteil zum Verschließen der Gehäuseöffnung. Die Trennwand steht beispielsweise parallel zum Verschlussteil. Beispielsweise ist das Verschlussteil temperierbar bzw. kühlbar, wobei es sich in diesem Fall bei dem mit einer Kühleinrichtung gekoppelten Gehäuseabschnitt um das Verschlussteil zum Verschließen der Gehäuseöffnung handelt.

Bei einer besonders vorteilhaften Ausgestaltung der Erfindung handelt es sich bei dem mit einer Kühleinrichtung gekoppelten Gehäuseabschnitt um einen Seitenwandabschnitt, insbesondere um einen Rahmenabschnitt eines Bodenwand und Deckwand miteinander verbindenden Rahmens des Gehäuses. Vorteilhaft umfasst bzw. enthält der mit einer Kühleinrichtung gekoppelte Gehäuseabschnitt ein Verschlussteil zum Verschließen einer Gehäuseöffnung.

Bei einer weiteren vorteilhaften Ausgestaltung der Erfindung weist der mit einer Kühleinrichtung gekoppelte Gehäuseabschnitt eine in den Zwischenraum mündende, (beispielsweise durch ein Ventil) verschließbare Gasdurchführung zum Abziehen/Zuführen mindestens eines gasförmigen Stoffs (z.B. Evakuieren und Einleiten von Prozessgas) auf. Eine solche Gasdurchführung ist beispielsweise mit einem Gasanschluss, insbesondere einem Ventil zur Steuerung des Gasstroms, versehen. Durch die Kühlung des Gehäuseabschnitts können in der Vakuumtechnik übliche Kunststoffdichtungen und andere vergleichsweise kostengünstige Standardkomponenten zur Vakuumabdichtung der Vorrichtung verwendet werden. Insbesondere handelt es bei dem gekühlten Gehäuseabschnitt mit Gasdurchführung um das Verschlussteil zum Verschließen der Gehäuseöffnung.

Eine nicht selbständig heizbare erfindungsgemäße Vorrichtung zum Wärmebehandeln eines Gegenstands kann beispielsweise als vorzugsweise gasdicht verschließbare (evakuierbare) Prozessbox zum Aufnehmen wenigstens eines flächigen Substrats, insbesondere zur Herstellung von Dünnschichtsolarzellen, ausgebildet sein. Die lichte Höhe des Hohlraums ist vorzugsweise so bemessen, dass in möglichst kurzer Zeit Gase abgepumpt und die hohen Anforderungen bezüglich Sauerstoffgehalt und Wasserpartialdruck bei einer RTP-Wärmebehandlung erfüllt werden können. Das Gehäuse kann grundsätzlich aus jedem für die beabsichtigte Verwendung geeigneten Material, beispielsweise Metall, Glas, Keramik, Glaskeramik, carbonfaserverstärkte Kohlenstoffwerkstoffe oder Graphit, gefertigt sein.

Wesentlich hierbei ist, dass das Gehäuse der Prozessbox einen oder mehrere Gehäuseabschnitte aufweist, die jeweils dazu ausgebildet sind, eine Wärmebehandlung durch auf den Gehäuseabschnitt auftreffende elektromagnetische Heizstrahlung zu ermöglichen. Die zur Wärmebehandlung dienenden Gehäuseabschnitte können zu diesem Zweck transparent, teiltransparent oder undurchsichtig sein für elektromagnetische Heizstrahlung zum Prozessieren des Substrats. Beispielsweise bestehen die zur Wärmebehandlung dienenden Gehäuseabschnitte aus Glaskeramik. Die zur Wärmebehandlung dienenden Gehäuseabschnitte können insbesondere auch ein Material (z.B. Graphit) enthalten oder aus einem solchen bestehen, welches geeignet ist, die elektromagnetische Heizstrahlung von Heizstrahlern zumindest teilweise, insbesondere vollständig, zu absorbieren, um selbst aufgeheizt zu werden. Der aufgeheizte Gehäuseabschnitt kann dann als sekundäre Wärmequelle zum Aufheizen des Substrats dienen, was insbesondere zu einer Homogenisierung der Wärmeverteilung führen kann. Das Gehäuse weist demnach mindestens einen mit einer Heizeinrichtung, wie beispielsweise Heizstrahler, gekoppelten Gehäuseabschnitt zum Heizen des Prozessraums auf. Zudem kann das Gehäuse der Prozessbox einen oder mehrere temperierbare bzw. kühlbare Gehäuseabschnitte umfassen, deren Temperatur auf einen vorgebbaren Temperaturwert einstellbar ist. Die Gehäuseabschnitte sind zu diesem Zweck jeweils mit einer (externen) Temperier- bzw. Kühleinrichtung wärmetechnisch gekoppelt. Des Weiteren umfasst das Gehäuse der Prozessbox in diesem Fall einen oder mehrere nicht temperierbare (d.h. nicht mit der Temperier- bzw. Kühleinrichtung gekoppelte) Gehäuseabschnitte, bei welchen es sich insbesondere um jene Gehäuseabschnitte handelt, die eine Wärmebehandlung durch auf den Gehäuseabschnitt auftreffende elektromagnetische Heizstrahlung ermöglichen, also im Strahlungsfeld der Heizstrahler liegen. Der Prozessraum wird ausschließlich von der wenigstens einen Trennwand und einem oder mehreren nicht temperierbaren bzw. kühlbaren Gehäuseabschnitten der Prozessbox umgrenzt.

Die Erfindung erstreckt sich weiterhin auf die Verwendung einer wie oben beschrieben ausgebildeten Trennwand in einem insbesondere gasdicht verschließbaren Gehäuse einer wie oben beschrieben ausgebildeten Vorrichtung zum Wärmebehandeln eines Gegenstands.

Ferner erstreckt sich die Erfindung auf ein Verfahren zum Wärmebehandeln eines Gegenstands, insbesondere eines beschichteten Substrats, bei welchem ein Gegenstand in einen Hohlraum eines insbesondere gasdicht verschließbaren Gehäuses eingebracht wird, wobei der Hohlraum durch eine Trennwand, welche über eine oder mehrere Öffnungen verfügt, in einen den Gegenstand aufnehmenden Prozessraum und einen Zwischenraum unterteilt wird, und der Gegenstand wärmebehandelt wird, wobei die Trennwand als Barriere für die Diffusion eines durch die Wärmebehandlung des Gegenstands im Prozessraum erzeugten gasförmigen Stoffs aus dem Prozessraum in den Zwischenraum wirkt.

Bei einer vorteilhaften Ausgestaltung des erfindungsgemäßen Verfahrens wird eine gesamte Öffnungsfläche der einen oder mehreren Öffnungen der Trennwand durch Erwärmen der Trennwand während der Wärmebehandlung auf maximal 50%, vorzugsweise maximal 30%, stärker bevorzugt maximal 10% einer gesamten Öffnungsfläche vor der Wärmebehandlung verringert.

Bei einer weiteren vorteilhaften Ausgestaltung des erfindungsgemäßen Verfahrens wird wenigstens ein den Zwischenraum begrenzender Gehäuseabschnitt, insbesondere ein Verschlussteil zum Verschließen einer Gehäuseöffnung, der insbesondere über eine in den Zwischenraum mündende Gasdurchführung zum Abziehen/Zuführen mindestens eines gasförmigen Stoffs verfügt, während der Wärmebehandlung des Gegenstands temperiert bzw. gekühlt.

Bei einer weiteren vorteilhaften Ausgestaltung des erfindungsgemäßen Verfahrens wird der mit dem Gegenstand versehene Hohlraum des Gehäuses, insbesondere vor und/oder nach der Wärmebehandlung, abgepumpt und mit wenigstens einem Gas befüllt. Vorteilhaft wird der Prozessraum durch Abziehen wenigstens eines gasförmigen Stoffs aus dem Zwischenraum abgepumpt und/oder wenigstens ein gasförmiger Stoff dem Prozessraum durch Einleiten in den Zwischenraum zugeführt. Die Vorteile eines solchen Verfahrens wurden bereits im Zusammenhang mit der erfindungsgemäßen Vorrichtung beschrieben, wobei zur Vermeidung von Wiederholungen auf die diesbezüglichen Ausführungen Bezug genommen wird.

### Kurze Beschreibung der Zeichnungen

Die Erfindung wird nun näher erläutert, wobei Bezug auf die beigefügten Figuren genommen wird. Es zeigen in vereinfachter, nicht maßstäblicher Darstellung:
- Fig. 1: eine verallgemeinerte Querschnittsdarstellung einer Vorrichtung zum Prozessieren eines beschichteten Substrats;
- Fig. 2: eine perspektivische Ansicht der Vorrichtung von Fig. 1 mit einem stirnseitigen Verschlussteil;
- Fig. 3: eine Variante der Vorrichtung von Fig. 2;
- Fig. 4: eine verallgemeinerte Querschnittsdarstellung einer Vorrichtung zum Prozessieren eines beliebigen Gegenstands;
- Fig. 5A-5F: verschiedene Varianten einer temperaturgesteuerten Trennwand der Vorrichtung von Fig. 1 bis 4.

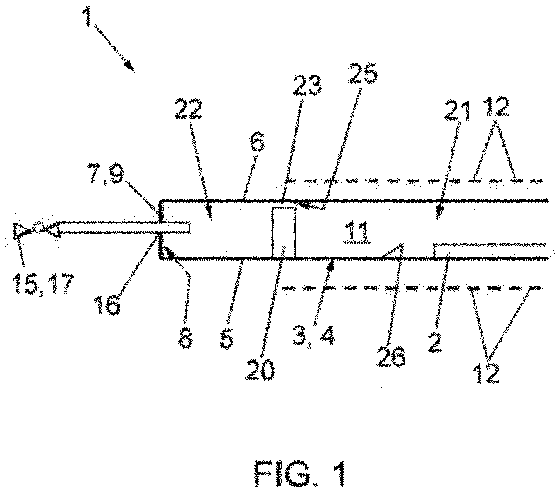

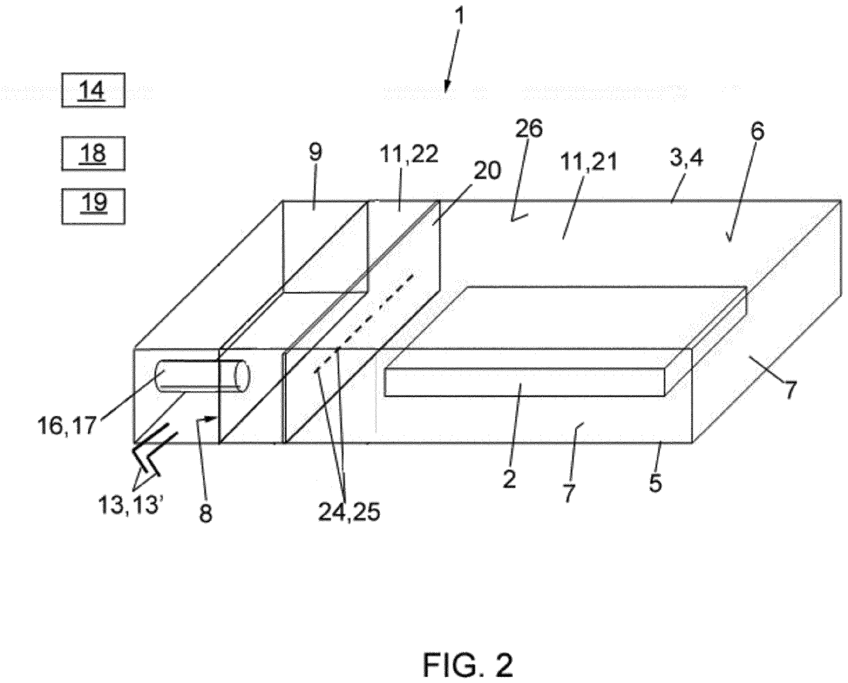

Seien zunächst Fig. 1 und 2 betrachtet, worin eine verallgemeinerte Schnittdarstellung einer Vorrichtung 1 zum Prozessieren eines Gegenstands 2 (Fig. 1), sowie eine perspektivische Ansicht einer solchen Vorrichtung 1 mit einem stirnseitigen Verschlussteil 9 (Fig. 2) gezeigt ist. Die Vorrichtung 1 dient beispielsweise zum Prozessieren eines einseitig beschichteten Substrats zur Wärmebehandlung von Vorläuferschichten zur Umsetzung zu einem Verbindungshalbleiter, insbesondere eine Chalkopyritverbindung. Obgleich nur ein einziges Substrat gezeigt ist, könnte die Vorrichtung 1 gleichermaßen zum Prozessieren zweier oder mehrerer Substrate eingesetzt werden. Das Substrat besteht beispielsweise aus Glas mit einer Dicke im Bereich von 1 mm bis 4 mm, insbesondere 2 mm bis 3 mm. Das Substrat ist mit einem nicht näher dargestellten Schichtenaufbau versehen, welcher beispielsweise aus Vorläuferschichten eines Absorbers (z.B. Chalkopyrit- oder Kesteritverbindung) besteht, die einer RTP-Wärmebehandlung unterzogen werden müssen. Beispielsweise handelt es sich bei dem Schichtenaufbau um eine Abfolge der Schichten Siliziumnitrid/Molybdän/Kupfer-Indium-Gallium/Selen. Beispielsweise hat die Siliziumnitrid-Schicht eine Dicke im Bereich von 50 nm bis 300 nm, die Molybdän-Schicht eine Dicke im Bereich von 200 nm bis 700 nm, die Kupfer-Indium-Gallium-Schicht eine Dicke im Bereich von 300 nm bis 1000 nm und die Selen-Schicht eine Dicke im Bereich von 500 nm bis 2000 nm.

Die Vorrichtung 1 umfasst ein hier beispielsweise quaderförmiges Gehäuse 3 mit einer Gehäusewand 4, die sich aus einer Bodenwand 5, einer Deckwand 6 und einer umlaufenden Seitenwand 7 zusammensetzt. Die Gehäusewand 4 umgrenzt einen gasdichten bzw. evakuierbaren Hohlraum 11, der durch ein abnehmbares Verschlussteil 9 gasdicht verschließbar ist. Wie in Fig. 2 gezeigt, kann das Gehäuse 3 beispielsweise eine stirnseitige Gehäuseöffnung 8 aufweisen, die durch ein türartig aufsetzbares Verschlussteil 9, welches einen Teil der Seitenwand 7 bildet, verschließbar ist. Allgemein können die Gehäuseöffnung 8 und das zugehörige Verschlussteil 9 wahlfrei an einem beliebigen Wandabschnitt der Gehäusewand 4 platziert sein. Die Bodenwand 5 dient in einem mittleren Bereich als Auflagefläche für das Substrat 2, wobei gleichermaßen auch entsprechende Abstandshalter bzw. Stützelemente vorgesehen sein können.

Die Gehäusewand 4 der Prozessbox 1 kann aus einem gleichen Material oder voneinander verschiedenen Materialien bestehen, beispielsweise Metall, Glas, Keramik, Glaskeramik carbonfaserverstärkte Kohlenstoffwerkstoffe oder Graphit.

In dem in Fig. 2 veranschaulichten Beispiel dient die Vorrichtung 1 als nicht selbständig heizbare Prozessbox zum Wärmebehandeln des als Substrat ausgeführten Gegenstands 2. Wesentlich hierbei ist, dass wenigstens ein Gehäuseabschnitt, hier beispielsweise die Deckwand 6 und die Bodenwand 5, jeweils so ausgebildet sind, dass eine Wärmebehandlung des beschichteten Substrats durch von außen in Form von elektromagnetischer Heizstrahlung zugeführte Wärmeenergie möglich ist. Die Wärmeenergie kann durch oberhalb der Deckwand 6 sowie unterhalb der Bodenwand 5 beispielsweise reihenförmig angeordnete Heizstrahler 12 zugeführt werden. Beispielsweise bestehen die Deckwand 6 und die Bodenwand 5 zu diesem Zweck aus einem Material, das transparent oder zumindest teiltransparent für die eingestrahlte elektromagnetische Strahlung ist, beispielsweise Glaskeramik. Die Deckwand 6 und die Bodenwand 5 können auch lediglich abschnittsweise aus einem solchen Material bestehen. Gleichermaßen ist es auch möglich, dass die Deckwand 6 und die Bodenwand 5 aus einem Material bestehen, welches geeignet ist, die elektromagnetische Strahlung zumindest teilweise, insbesondere vollständig, zu absorbieren, um selbst aufgeheizt zu werden, beispielsweise Graphit. In diesem Fall dienen die Deckwand 6 und die Bodenwand 5 als passiv geheizte, sekundäre Wärmequellen.

Wie in Fig. 2 erkennbar, ist die Gehäusewand 4, hier beispielsweise das Verschlussteil 9, mit zwei Kühlmittelanschlüssen 13, 13' versehen, die als Ein- bzw. Auslass für Kühlmittel in ein nicht näher dargestelltes, die umlaufende Seitenwand 7 wenigstens abschnittsweise, insbesondere vollständig, durchziehendes Kühlmittelleitungssystem dienen. Durch das eingeleitete Kühlmittel kann die Seitenwand 7 wenigstens abschnittsweise, insbesondere vollständig auf eine voreinstellbare Temperatur temperiert (in Bezug auf die Substrattemperaturen bei der Wärmebehandlung aktiv gekühlt) werden. Die beiden Kühlmittelanschlüsse 13, 13' können zu diesem Zweck mit einer Temperier- bzw. Kühleinrichtung 14 zum Aufbereiten und Kühlen des Kühlmittels strömungstechnisch verbunden werden. Allgemein werden in der Vorrichtung 1 nur jene Gehäuseabschnitte temperiert, welche nicht zur Wärmebehandlung des beschichteten Substrats durch von außen in Form von elektromagnetischer Heizstrahlung zugeführte Wärmeenergie dienen, hier beispielsweise die umlaufende Seitenwand 7 oder zumindest ein Abschnitt hiervon. Im vorliegenden Beispiel wird lediglich das Verschlussteil 9 temperiert (gekühlt). Als Kühlmittel kann beispielsweise Öl oder Wasser verwendet werden. Die Temperierung bzw. aktive Kühlung kann alternativ auch durch eine Kontaktkühlung (Wärmeleitung) durch Kontakt mit Kühlkörpern (beispielsweise Kühlplatten), ein Gebläse (Konvektionskühlung) oder kontaktlos durch beabstandete Kühlkörper (Strahlungskühlung) erreicht werden.

Das Gehäuse 3 umfasst weiterhin eine mit einem Ventil 15 versehene Gasdurchführung 16, die in den Hohlraum 11 mündet. Die Gasdurchführung 16 ist hier beispielsweise im stirnseitigen Verschlussteil 9 angeordnet. Über einen Gasanschluss 17 kann durch Anschluss an eine Abpumpeinrichtung 18 (z.B. Vakuumpumpe) der Hohlraum 11 evakuiert werden. Zudem kann der Gasanschluss 17 an eine Gasversorgungseinrichtung 19 angeschlossen werden, um den Hohlraum 11 durch Einleiten eines inerten Spülgases zu spülen oder mit einem reaktiven Prozessgas zu füllen. Eine Befüllung mit Prozessgas kann mit Unter- oder Überdruck erfolgen. Durch das Ventil 15 (beispielsweise ein Mehrwegeventil) kann die Gasdurchführung 16 wahlfrei geöffnet bzw. gasdicht verschlossen werden. Der Hohlraum 11 hat eine relativ geringe lichte Höhe, die beispielsweise im Bereich von 7 bis 12 mm liegt, um ein zügiges Evakuieren und effizientes Befüllen mit Prozessgas zu ermöglichen.

Der Hohlraum 11 ist durch eine leistenförmige Trennwand 20 in einen Prozessraum 21 und einen Zwischenraum 22 quasi-gasdicht unterteilt, wobei der als beschichtetes Substrat ausgeführte Gegenstand 2 ausschließlich im Prozessraum 21 aufgenommen ist. Die Gasdurchführung 16 mündet in den Zwischenraum 22. Die Trennwand 20 ist mit einer oder mehreren Öffnungen bzw. Durchbrechungen versehen, durch welche der Prozessraum 21 mit dem Zwischenraum 22 strömungstechnisch verbunden ist.

Wie in der Vertikalschnittdarstellung von Fig. 1 erkennbar, reicht die Trennwand 20, welche sich in vertikaler Richtung von der Bodenwand 5 in Richtung zur Deckwand 6 erstreckt, nicht ganz bis zur Deckwand 6 heran, so dass ein Spalt 23 als Öffnung der Trennwand 20 verbleibt. In Fig. 2 ist eine Variante der Trennwand 20 gezeigt, bei welcher sich die Trennwand 20 bis zur Deckwand 6 erstreckt und mit einer Mehrzahl, etwa mittig in einer Reihe angeordneten, horizontalen Schlitzen 24 als Öffnungen versehen ist. Durch den Spalt 23 bzw. Schlitze 24 ist der Prozessraum 21 mit dem Zwischenraum 22 strömungstechnisch verbunden, so dass ein wechselseitiger Gasaustausch möglich ist, jedoch aufgrund der geringen vertikalen Abmessung bzw. Höhe des Spalts 23 bzw. Schlitze 24 gehemmt ist. Die Trennwand 20 wirkt somit als Diffusions- bzw. Dampfbarriere zwischen Prozessraum 21 und Zwischenraum 22.

Die Eigenschaft der Trennwand 20 als Diffusions- bzw. Dampfbarriere zu wirken, beruht auf der Druckabhängigkeit der freien Weglänge: bei nahezu Normaldruck (700-1000mbar) ist die Diffusion durch die vergleichsweise kleine(n) Öffnung(en) der Trennwand 20 gehemmt. Wird der Zwischenraum 22 dagegen auf Drücke im Vorvakuumbereich (10-1000pbar) abgepumpt, ist die freie Weglänge stark erhöht und die Trennwand 20 stellt nur noch eine schwache Diffusionsbarriere für den Gasaustausch dar. Der Prozessraum 21 kann somit durch die Trennwand 20 hindurch abgepumpt werden und Prozessgas kann nach dem Abpumpen durch Einlass in den Zwischenraum 22 auch in den Prozessraum 21 strömen. Andererseits kann durch die Trennwand 20 der Partialdruck von leicht flüchtigen Chalkogenkomponenten wie Selen oder Schwefel im Prozessraum 21, die während der Wärmebehandlung vom beschichteten Substrat ausdiffundieren/verdampfen, während der Wärmebehandlung des Substrats zumindest weitestgehend konstant gehalten werden. Die Trennwand 20 wirkt somit beispielsweise als Selenbarriere bei der Wärmebehandlung des beschichteten Substrats.

Allgemein ist eine (gemeinsame) Öffnungsfläche 25 des Spalts 23 bzw. Schlitze 24 so bemessen, dass während der Wärmebehandlung des Substrats ein Massenverlust eines durch die Wärmebehandlung des beschichteten Substrats erzeugten gasförmiges Stoffs aus dem Prozessraum 21 weniger als 50%, vorzugsweise weniger als 20%, stärker bevorzugt weniger als 10%, der Masse des während der Wärmebehandlung im Prozessraum 21 erzeugten gasförmigen Stoffs beträgt. Zu diesem Zweck ist die Trennwand 20 so ausgebildet, dass ein Flächenverhältnis, gebildet aus der Öffnungsfläche 25 geteilt durch eine innere Oberfläche bzw. Innenfläche 26 des Prozessraums 21, im Bereich von 5 x 10⁻⁵ bis 5 x 10⁻⁴ liegt.

Beispielsweise hat die Innenfläche 26 des Prozessraums 21 eine Größe von ca. 1,2 m². Eine mittlere Spalthöhe des Spalts 23 liegt beispielsweise im Bereich von 50 bis 100 µm, entsprechend einer Öffnungsfläche 25 im Bereich von 2 bis 5 cm². Die Trennwand 20 hat beispielsweise eine Höhe von 9 mm. Aus diesen Werten ergibt sich ein Flächenverhältnis von 1,5 x 10⁻⁴.

Durch die als Dampf- bzw. Diffusionsbarriere dienende Trennwand 20 kann eine Diffusion von während der Wärmebehandlung im Prozessraum 21 entstehenden flüchtigen Komponenten in den Zwischenraum 22 zumindest weitestgehend unterbunden werden, so dass eine Kondensation der flüchtigen Komponenten an der temperierten (aktiv gekühlten) Seitenwand 7, hier speziell Verschlussteil 9, verhindert wird. Die Prozessatmosphäre im Prozessraum 21 kann somit zumindest annähernd konstant gehalten werden.

Wie in Fig. 1 veranschaulicht, befindet sich der Zwischenraum 22 zumindest teilweise, insbesondere vollständig, außerhalb eines (gemeinsamen) Strahlungsfelds der Heizstrahler 12, so dass sich während der Wärmebehandlung ein Temperaturgradient im Zwischenraum 22 von der Trennwand 20 zur temperierten (aktiven gekühlten) Seitenwand 7, hier speziell Verschlussteil 9, ausbildet. Dieser Temperaturgradient dient als "Temperaturbarriere" zum Schutz von vakuumfähigen Komponenten der Prozessbox 1 vor hoher thermischer Belastung. Zu diesem Zweck sind die Heizstrahler 12 ausschließlich ober- bzw. unterhalb des Prozessraums 21 vor bzw. bis zur Trennwand 20 angeordnet. Die Heizstrahler 12 enden jeweils zumindest einige Zentimeter vor dem Zwischenraum 22 oder Trennwand 20. Andererseits sind die Heizstrahler 12 so angeordnet, dass sich ein ansteigender Temperaturgradient derart ausbildet, dass eine gewünschte Prozesstemperatur zum Wärmebehandeln des beschichteten Substrats 2 ausgehend von der Seitenwand 7, speziell Verschlussteil 9, hin zur Trennwand 20 vor oder wenigstens auf Höhe der Trennwand 20 erreicht wird, um eine ausreichende Umsetzung der Vorläuferschichten des Substrats zum Verbindungshalbleiter sicherzustellen.

In der in Fig. 1 veranschaulichten allgemeinen Ausführungsform können die Trennwand 20, der Zwischenraum 22 und der(die) temperierbare(n) Abschnitt(e) der Seitenwand 7 seitlich in einer Richtung, in zwei Richtungen oder umlaufend (Rahmen) ausgestaltet sein. In der Ausführungsform von Fig. 2 sind Trennwand 20, Zwischenraum 22 und der temperierbare bzw. kühlbare Abschnitt der Seitenwand 7 (Verschlussteil 9) nur in einer Raumrichtung ausgeführt.

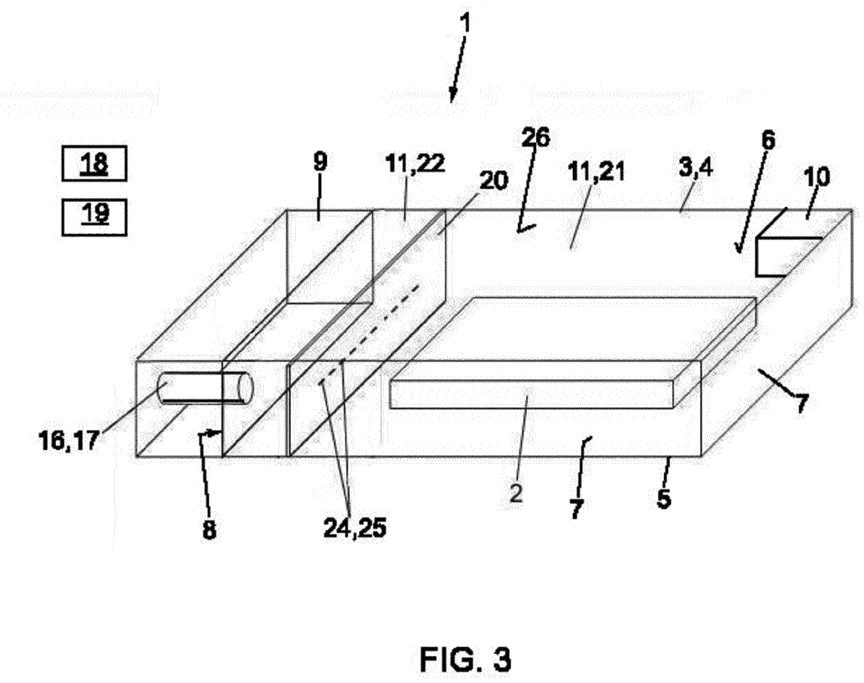

In Fig. 3 ist eine Variante der Vorrichtung 1 veranschaulicht, wobei lediglich die Unterschiede zur Vorrichtung von Fig. 1 und 2 erläutert werden und ansonsten auf die diesbezüglichen Ausführungen Bezug genommen wird.

Demnach ist die Vorrichtung 1 als Temperofen selbständig heizbar und umfasst zu diesem Zweck eine Heizeinrichtung 10, die hier beispielsweise (nur) im Prozessraum 21 aufgenommen ist. Die Heizeinrichtung 10 ist beispielsweise als elektrische (Widerstands-)Heizung ausgebildet. Eine Heizung des Gegenstands 2 durch Heizstrahler 12 ist nicht vorgesehen. Dementsprechend kann das Gehäuse 3 auch aus einem einheitlichen Material bestehen, beispielsweise Keramik, Quarz oder Metall. Weiterhin ist eine Temperierung des Verschlussteils 9 nicht vorgesehen. Beispielsweise befindet sich im Zwischenraum 22 ein Sensor (nicht gezeigt), der vor korrosiven Gasen des Prozessraums durch die Trennwand 12 geschützt werden soll.

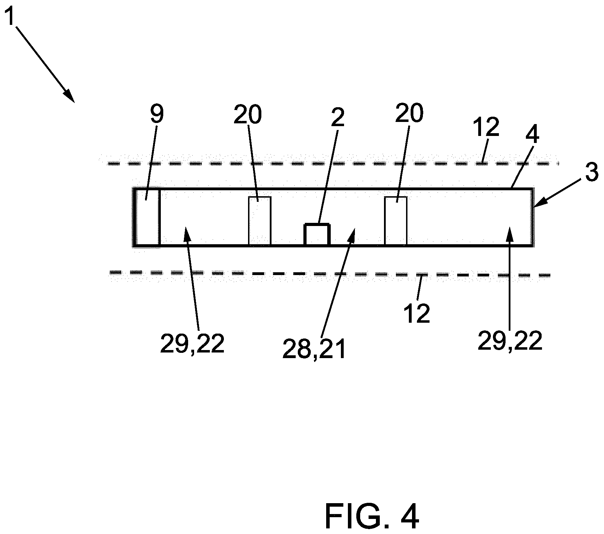

In Fig. 4 ist eine verallgemeinerte Querschnittsdarstellung einer erfindungsgemäßen Vorrichtung 1 zum Prozessieren eines beliebigen Gegenstands 2 veranschaulicht, wobei lediglich die Unterschiede zur Vorrichtung von Fig. 1 und 2 erläutert werden und ansonsten auf die diesbezüglichen Ausführungen Bezug genommen wird.

Demnach dient die Vorrichtung 1 zur Prozessierung, insbesondere Beschichtung, eines beliebigen Gegenstandes 2. Der Querschnitt könnte zum Beispiel einen üblichen Zonenofen darstellen mit mehreren Heizzonen, hier beispielsweise eine innere heiße Kernzone 28 zum Prozessieren des Gegenstands 2, die von zwei kälteren Randzonen 29 umgeben ist. Die wärmere Kernzone 28 weist demnach auch eine wärmere Gehäusewand 4 auf als die kälteren Randzonen 29. Die Vorrichtung 1 umfasst hier beispielsweise ein zylinderförmiges Gehäuse 3 als Teil eines Temperofens mit einer Heizeinrichtung 10, die einen Widerstandsheizer (nicht gezeigt) und Heizstrahler 12 umfasst. Die Trennwand 20 trennt dabei zum Beispiel die heißeste Kernzone 28 des Zonenofens, in dem der Gegenstand 2 liegt, und die Randzonen 29 voneinander. Eine Temperierung des Verschlussteils 9 ist in der Vorrichtung 1 von Fig. 4 nicht vorgesehen.

Durch die als Dampf- bzw. Diffusionsbarriere dienende Trennwand 20 kann eine Diffusion von während der Wärmebehandlung in der Kernzone 28 entstehenden flüchtigen Komponenten in die Randzonen 29 zumindest weitestgehend unterbunden werden, so dass eine Kondensation der flüchtigen Komponenten an der kälteren Gehäusewand 4 der Randzonen 29 verhindert wird.

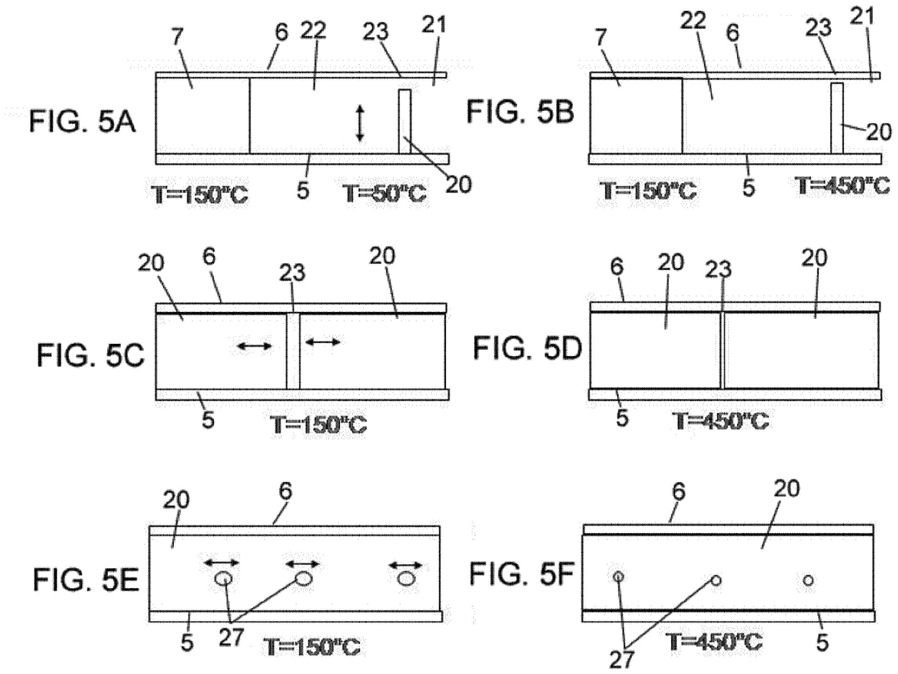

Es wird nun Bezug auf Fig. 5A-5F genommen, worin verschiedene Varianten der Trennwand 20 der erfindungsgemäßen Vorrichtung 1 veranschaulicht sind. Es handelt sich jeweils um eine temperaturgesteuerte Trennwand 20, welche zu diesem Zweck aus einem Material besteht, das einen solchen Wärmeausdehnungskoeffizienten hat, dass sich eine gesamte Öffnungsfläche 25 der jeweiligen Öffnungen bzw. Durchbrechungen durch Erwärmen der Trennwand 20 während der Wärmebehandlung auf maximal 50%, vorzugsweise maximal 30%, stärker bevorzugt maximal 10%, des Ausgangswerts (gesamte Öffnungsfläche 25 vor der Wärmebehandlung) verringert. Die Trennwand 20 besteht zu diesem Zweck aus einem Material mit einem Wärmeausdehnungskoeffizienten von mehr als 5 x 10⁻⁶K⁻¹. Beispiele hierfür sind bestimmte Glaskeramiken mit einem Wärmeausdehnungskoeffizienten von 9 x 10⁻⁶ K⁻¹, Aluminiumoxid (Al₂O₃) mit einem Wärmeausdehnungskoeffizienten im Bereich von 6,5 x 10⁻⁶ K⁻¹ bis 9 x 10⁻⁶ K⁻¹, Zirkonoxid und Magnesiumoxid mit einem Wärmeausdehnungskoeffizienten im Bereich von 10 x 10⁻⁶ K⁻¹ bis 13 x 10⁻⁶ K⁻¹. Das Material der Trennwand 20 muss zudem temperaturbeständig und korrosionsresistent sein.

In Fig. 5A und 5B ist die als vertikale Leiste ausgebildete Trennwand 20 der Prozessbox 1 jeweils in einer Vertikalschnittdarstellung gezeigt. Demnach reicht die Trennwand 20 nicht bis zur Deckwand 6, so dass der Spalt 23 als Öffnung zur strömungstechnischen Verbindung von Prozessraum 21 und Zwischenraum 22 verbleibt. In Fig. 4A ist eine Situation gezeigt, bei der die Seitenwand 7 auf eine Temperatur T=150°C temperiert ist, während die Trennwand 20 eine Temperatur T=50°C hat. Das Material der Trennwand 20 ist relativ kalt, der Spalt 23 weit offen. Die vertikale Abmessung bzw. mittlere Spalthöhe (lichte Weite) des Spalts 23 liegt im Bereich von 50 bis 100 µm bei einer Höhe der Trennwand 20 von ca. 10 mm. Bei Erwärmung dehnt sich das Material der Trennwand 20 relativ stark aus, wobei sich die mittlere Spalthöhe verringert (Fig. 5B). Beispielsweise erhält man bei einer Erwärmung der Trennwand 20 auf eine Temperatur T=450°C (Temperaturdifferenz 400°C) eine Änderung der vertikalen Abmessung der Trennwand 20 von ca. 40 µm, so dass sich die mittlere Spalthöhe des Spalts 23 auf einen Wert im Bereich von 10 bis 50 µm, also maximal 50% des Ausgangswerts, verringert. In diesem Fall ist es wesentlich, dass die Höhe des Prozessraums 21 sich durch Wärmeausdehnung weniger vergrößert als der Spalt 23. Das kann zum Beispiel dadurch erreicht werden, dass das Material des Prozessraums 21 in Fig. 2 aus Quarzglas (Wärmeausdehnungskoeffizient 5*10⁻⁷ /K) oder einem anderen Material mit einem Wärmeausdehnungskoeffizienten kleiner als 1*10⁻⁶ /K besteht. Alternativ kann auch, wie im Aufbau nach Fig. 1 dargestellt, die Höhe des Gehäuses 3 durch die Temperierung der Seitenwand 7 konstant gehalten werden.

In den Fig. 5C und 5D ist anhand einer Aufsicht auf die Trennwand 20 eine Variante gezeigt. Um unnötige Wiederholungen zu vermeiden, werden lediglich die Unterschiede zu Fig. 5A und 5B erläutert und ansonsten wird auf die dortigen Ausführungen Bezug genommen. Demnach erstreckt sich die leistenförmige Trennwand 20 von der Bodenwand 5 zur Deckwand 6, wobei ein oder mehrere vertikale Spalten 23 in Form von Durchbrechungen der Trennwand 20 ausgebildet sind. Die in horizontaler Richtung sich bemessende Spaltbreite liegt im Bereich von 50 bis 100 µm (Fig. 5C). Durch eine im Vergleich zur Höhe von 10 mm größere Abmessung der Trennwandbereiche zwischen zwei Spalten 23 kann bei Erwärmung der Trennwand 20 auf eine Temperatur von beispielsweise T=450°C ein relativ großer Hub erreicht werden, welcher beispielsweise mehrere 100 µm betragen kann. Insbesondere kann hierbei die gesamte Öffnungsfläche der Spalten 23 auf beispielsweise maximal 50% des Ausgangswerts reduziert werden.

In den Fig. 5E und 5F ist anhand einer Aufsicht auf die Trennwand 20 eine weitere Variante gezeigt. Um unnötige Wiederholungen zu vermeiden, werden wiederum lediglich die Unterschiede zu Fig. 5A und 5B erläutert und ansonsten wird auf die dortigen Ausführungen Bezug genommen. Demnach ist anstelle eines Spaltes 23 eine Mehrzahl Rundlöcher 27 vorgesehen, die jeweils in Form von Durchbrechungen der Trennwand 20 ausgebildet sind. Ausgehend von einer Situation, bei welcher die Temperatur der Trennwand 20 beispielsweise T=150°C beträgt (Fig. 4E), kann durch eine Erwärmung der Trennwand 20 auf eine Temperatur von beispielsweise T=450°C eine Verringerung des Öffnungsdurchmessers der Rundlöcher 27 erreicht werden (Fig. 4F). Insbesondere kann hierbei die gesamte Öffnungsfläche der Rundlöcher 27 auf beispielsweise maximal 50% des Ausgangswerts reduziert werden.

### Bezugszeichenliste

- 1: Vorrichtung
- 2: Gegenstand
- 3: Gehäuse
- 4: Gehäusewand
- 5: Bodenwand
- 6: Deckwand
- 7: Seitenwand
- 8: Gehäuseöffnung
- 9: Verschlussteil
- 10: Heizeinrichtung
- 11: Hohlraum
- 12: Heizstrahler
- 13, 13': Kühlmittelanschluss
- 14: Kühleinrichtung
- 15: Ventil
- 16: Gasdurchführung
- 17: Gasanschluss
- 18: Abpumpeinrichtung
- 19: Gasversorgungseinrichtung
- 20: Trennwand
- 21: Prozessraum
- 22: Zwischenraum
- 23: Spalt
- 24: Schlitz
- 25: Öffnungsfläche
- 26: Innenfläche
- 27: Rundloch
- 28: Kernzone
- 29: Randzone

## Patentansprüche

1. Vorrichtung (1) zum Wärmebehandeln eines Gegenstands (2), insbesondere eines beschichteten Substrats, mit einem insbesondere gasdicht verschließbaren Gehäuse (3) das einen Hohlraum (11) umgrenzt, wobei der Hohlraum (11) eine Trennwand (20) aufweist, durch die der Hohlraum (11) in einen Prozessraum (21) zum Aufnehmen des Gegenstands (2) und einen Zwischenraum (22) unterteilt ist, wobei die Trennwand (20) über eine oder mehrere Öffnungen (23, 24) verfügt, bei welcher das Gehäuse (3)wenigstens einen mit einer Kühleinrichtung (14)zu dessen aktiven Kühlung gekoppelten Gehäuseabschnitt (9) aufweist, **dadurch gekennzeichnet, dass** die eine oder mehrere Öffnungen so ausgebildet sind, dass die Trennwand (20) als Barriere für die Diffusion eines durch die Wärmebehandlung des Gegenstands (2) im Prozessraum (21) erzeugten gasförmigen Stoffs aus dem Prozessraum (21) in den Zwischenraum (22) wirkt, wobei die Trennwand (20) zwischen dem Gegenstand (2) und dem kühlbaren Gehäuseabschnitt (9) angeordnet ist.

2. Vorrichtung (1) nach Anspruch 1, bei welcher die Trennwand (20) so ausgebildet ist, dass ein Massenverlust des gasförmigen Stoffs während der Wärmebehandlung weniger als 50%, vorzugsweise weniger als 20%, stärker bevorzugt weniger als 10%, beträgt, wobei ein Flächenverhältnis, gebildet aus einer gesamten Öffnungsfläche (25) der einen oder mehreren Öffnungen (23, 24) geteilt durch eine innere Oberfläche (26) des Prozessraums (21), im Bereich von 5 x 10⁻⁵ bis 5 x 10⁻⁴ liegt.

3. Vorrichtung (1) nach einem der Ansprüche 1 oder 2, bei welcher die Trennwand (20) ein Material enthält, das einen solchen Wärmeausdehnungskoeffizienten hat, dass sich eine gesamte Öffnungsfläche (25) der einen oder mehreren Öffnungen (23, 24) durch Erwärmen der Trennwand (20) während der Wärmebehandlung auf maximal 50%, vorzugsweise maximal 30%, stärker bevorzugt maximal 10%, einer gesamten Öffnungsfläche (25) vor der Wärmebehandlung verringert.

4. Vorrichtung (1) nach Anspruch 3, bei welcher die Trennwand (20) ein Material enthält, dessen Wärmeausdehnungskoeffizient größer als 5 x 10⁻⁶ K⁻¹ ist.

5. Vorrichtung (1) nach einem der Ansprüche 1 bis 4, bei welcher das Gehäuse (3) aus einem Material besteht, dessen Wärmeausdehnungskoeffizient kleiner als 5 x 10⁻⁶ K⁻¹ ist, beispielsweise Quarzglas.

6. Vorrichtung (1) nach einem der Ansprüche 1 bis 5, welche eine Heizeinrichtung (10) zum Heizen des Prozessraums (21) für eine Wärmebehandlung des Gegenstands (2) umfasst und/oder bei welcher das Gehäuse (3) wenigstens einen Gehäuseabschnitt (5, 6) umfasst, der so ausgebildet ist, dass der Gegenstand durch auf den Gehäuseabschnitt auftreffende elektromagnetische Heizstrahlung wärmebehandelbar ist und/oder bei welcher das Gehäuse (3) mindestens einen mit einer Heizeinrichtung (12) gekoppelten Gehäuseabschnitt (5, 6) zum Heizen des Prozessraums (21) aufweist.

7. Vorrichtung (1) nach einem der Ansprüche 1 bis 6, bei welcher die Trennwand (20) zwischen einer wärmeren Zone (28) und wenigstens einer kälteren Zone (29) des Hohlraums (11) angeordnet ist.

8. Vorrichtung (1) nach einem der Ansprüche 1 bis 7, bei welcher der mit einer Kühleinrichtung (14) gekoppelte Gehäuseabschnitt (9) eine in den Zwischenraum (22) mündende, verschließbare Gasdurchführung (16) zum Abziehen/Zuführen mindestens eines gasförmigen Stoffs aufweist.

9. Vorrichtung (1) nach einem der Ansprüche 1 bis 8, bei welcher der mit einer Kühleinrichtung (14) gekoppelte Gehäuseabschnitt (9) ein Seitenwandabschnitt (7) des Gehäuses (3) ist, welcher insbesondere ein Verschlussteil (9) zum Verschließen einer Gehäuseöffnung (8) enthält.

10. Vorrichtung (1) nach einem der Ansprüche 1 bis 9, bei welcher die Trennwand (20) nicht bis zu einer Gehäusewand (6) reicht, wobei eine Öffnung, insbesondere ein Spalt (23), zwischen Trennwand (20) und Gehäusewand (6) verbleibt.

11. Verwendung einer Trennwand (20) in einem insbesondere gasdicht verschließbaren Gehäuse (3) in einer Vorrichtung (1) zum Wärmebehandeln eines Gegenstands (2), wobei das Gehäuse (3) einen Hohlraum (11) umgrenzt, der durch die Trennwand (20) in einen Prozessraum (21) zum Aufnehmen des Gegenstands (2) und einen Zwischenraum (22) unterteilt ist, wobei das Gehäuse (3) wenigstens einen mit einer Kühleinrichtung (14) zu dessen aktiven Kühlung gekoppelten Gehäuseabschnitt (9) aufweist, **dadurch gekennzeichnet, dass** die Trennwand (20) zwischen dem Gegenstand (2) und dem kühlbaren Gehäuseabschnitt (9) angeordnet ist und wobei die Trennwand (20) über eine oder mehrere Öffnungen (23, 24) verfügt, die so ausgebildet sind, dass die Trennwand (20) als Barriere für die Diffusion eines durch die Wärmebehandlung des Gegenstands (2) im Prozessraum (21) erzeugten gasförmigen Stoffs aus dem Prozessraum (21) in den Zwischenraum (22) wirkt.

12. Verwendung nach Anspruch 11, bei welcher die Trennwand (20) so ausgebildet ist, dass ein Massenverlust des gasförmigen Stoffs während der Wärmebehandlung weniger als 50%, vorzugsweise weniger als 20%, stärker bevorzugt weniger als 10%, beträgt, wobei die Trennwand (20) so ausgebildet ist, dass ein Flächenverhältnis, gebildet aus einer gesamten Öffnungsfläche (25) der einen oder mehreren Öffnungen (23, 24) geteilt durch eine innere Oberfläche (26) des Prozessraums (21), im Bereich von 5 x 10⁻⁵ bis 5 x 10⁻⁴ liegt.

13. Verwendung nach einem der Ansprüche 11 oder 12, bei welcher die Trennwand (20) einen solchen Wärmeausdehnungskoeffizienten hat, dass sich eine gesamte Offnungsfläche (25) der einen oder mehreren Öffnungen (23, 24) durch Erwärmen der Trennwand während der Wärmebehandlung des Gegenstands (2) auf maximal 50%, vorzugsweise maximal 30%, stärker bevorzugt maximal 10%, einer gesamten Öffnungsfläche vor der Wärmebehandlung verringert, wobei die Trennwand (20) insbesondere ein Material mit einem Wärmeausdehnungskoeffizienten von mehr als 5 x 10⁻⁶ K⁻¹ enthält.

14. Verfahren zum Wärmebehandeln eines Gegenstands (2), insbesondere eines beschichteten Substrats, mit den folgenden Schritten:
- Einbringen eines Gegenstands in einen Hohlraum (11) eines insbesondere gasdicht verschließbaren Gehäuses (3), wobei der Hohlraum durch eine Trennwand (20), welche über eine oder mehrere Öffnungen (23, 24) verfügt, in einen den Gegenstand aufnehmenden Prozessraum (21) und einen Zwischenraum (22) unterteilt wird,
- Wärmebehandeln des Gegenstands (2), wobei die Trennwand (20) als Barriere für die Diffusion eines durch die Wärmebehandlung des Gegenstands (2) im Prozessraum (21) erzeugten gasförmigen Stoffs aus dem Prozessraum (21) in den Zwischenraum (22) wirkt,
- Kühlen wenigstens eines den Zwischenraum (22) begrenzender Gehäuseabschnitts (9) während der Wärmebehandlung des Gegenstands.

15. Verfahren nach Anspruch 14, bei welchem der Prozessraum (21) durch Abziehen wenigstens eines gasförmigen Stoffs aus dem Zwischenraum (22) abgepumpt und/oder wenigstens ein gasförmiger Stoff dem Prozessraum (21) durch Einleiten in den Zwischenraum (22) zugeführt wird.

## Claims

1. Device (1) for heat treating an object (2), in particular a coated substrate, with an in particular gas-tightly sealable housing (3) that encloses a hollow space (11), wherein the hollow space (11) has a separating wall (20), by means of which the hollow space (11) is divided into a process space (21) for accommodating the object (2) and an intermediate space (22), wherein the separating wall (20) has one or a plurality of openings (23, 24), wherein the housing (3) has at least one housing section (9) coupled with a cooling device (14) for its active cooling, **characterized in that** the one or a plurality of openings are implemented such that the separating wall (20) acts as a barrier for the diffusion out of the process space (21) into the intermediate space (22) of a gaseous substance generated in the process space (21) by the heat treatment of the object (2), wherein the separating wall (20) is arranged between the object (2) and the coolable housing section (9).

2. Device (1) according to claim 1, wherein the the separating wall (20) is implemented such that a mass loss of the gaseous substance during the heat treatment is less than 50%, preferably less than 20%, more preferably less than 10%, wherein an area ratio, formed from a total opening area (25) of the one or a plurality of openings (23, 24) divided by an inner surface (26) of the process space (21), is in the range from 5 x 10⁻⁵ to 5 x 10⁻⁴.

3. Device (1) according to one of claims 1 or 2, wherein the separating wall (20) contains a material, which has such a coefficient of thermal expansion that a total opening area (25) of the one or a plurality of openings (23, 24) is reduced by heating the separating wall (20) during the heat treatment to a maximum of 50%, preferably a maximum of 30%, more preferably a maximum of 10%, of a total opening area (25) before the heat treatment.

4. Device (1) according to claim 3, wherein the separating wall (20) contains a material, whose coefficient of thermal expansion is greater than 5 x 10⁻⁶ K⁻¹.

5. Device (1) according to one of claims 1 through 4, wherein the housing (3) is made of a material, whose coefficient of thermal expansion is less than 5 x 10⁻⁶ K⁻¹, for example, quartz glass.

6. Device (1) according to one of claims 1 through 5, which comprises a heating device (10) for heating the process space (21) for heat treatment of the object (2) and/or wherein the housing (3) comprises at least one housing section (5, 6), which is implemented such that the object is heat treatable by means of electromagnetic thermal radiation impinging on the housing and/or wherein the housing (3) has at least one housing section (5, 6) coupled to a heating device (12) for heating the process space (21).

7. Device (1) according to one of claims 1 through 6, wherein the separating wall (20) is arranged between a warmer zone (28) and at least one colder zone (29) of the hollow space (11).

8. Device (1) according to one of claims 1 through 7, wherein the housing section (9) coupled to a cooling device (14) has a sealable gas passage (16) opening into the intermediate space (22) for removing/feeding at least one gaseous substance.

9. Device (1) according to one of claims 1 through 8, wherein the housing section (9) coupled to a cooling device (14) is a side wall section (7) of the housing (3), which includes in particular a seal (9) for sealing a housing opening (8).

10. Device (1) according to one of claims 1 through 9, wherein the separating wall (20) does not reach a housing wall (6), wherein an opening, in particular a gap (23), remains between the separating wall (20) and the housing wall (6).

11. Use of a separating wall (20) in an in particular gas-tightly sealable housing (3) in a device (1) for heat treating an object (2), wherein the housing (3) encloses a hollow space (11), which is divided by the separating wall (20) into a process space (21) for accommodating the object (2) and an intermediate space (22), wherein the housing (3) has at least one housing section (9) coupled to a cooling device (14) for its active cooling, **characterized in that** the separating wall (20) is arranged between the object (2) and the coolable housing section (9) and wherein the separating wall (20) has one or a plurality of openings (23, 24), which are implemented such that the separating wall (20) acts as a barrier for the diffusion out of the process space (21) into the intermediate space (22) of a gaseous substance generated in the process space (21) by the heat treatment of the object (2).

12. Use according to claim 11, wherein the separating wall (20) is implemented such that a mass loss of the gaseous substance during the heat treatment is less than 50%, preferably less than 20%, more preferably less than 10%,, wherein the separating wall (20) is implemented such that an area ratio, formed from a total opening area (25) of the one or a plurality of openings (23, 24) divided by an inner surface (26) of the process space (21), is in the range from 5 x 10⁻⁵ to 5 x 10⁻⁴.

13. Use according to one of claims 11 or 12, wherein the separating wall (20) has such a coefficient of thermal expansion, that a total opening area (25) of the one or a plurality of openings (23, 24) is reduced by heating the separating wall during the heat treatment of the object (2) to a maximum of 50%, preferably a maximum of 30%, more preferably a maximum of 10%, of a total opening area before the heat treatment, wherein the separating wall (20) contains in particular a material with a coefficient of thermal expansion of more than 5 x 10⁻⁶ K⁻¹.

14. Method for heat treating an object (2), in particular a coated substrate, with the following steps:
- Introducing an object into a hollow space (11) of an in particular gas-tightly sealable housing (3), wherein the hollow space is divided by a separating wall (20), which has one or a plurality of openings (23, 24), into a process space (21) accommodating the object and an intermediate space (22),
- Heat treating the object (2), wherein the separating wall (20) acts as a barrier for the diffusion process space (21) into the intermediate space (22) of a gaseous substance generated in the process space (21) by the heat treatment of the object (2),
- Cooling at least one housing section (9) delimiting delimiting the intermediate space (22) during the heat treatment of the object.

15. Method according to claim 14, wherein the process space (21) is pumped out by by removal of at least one gaseous substance from the intermediate space (22) and/or at least one gaseous substance is fed to the process space (21) by introduction into the intermediate space (22).

## Revendications

1. Dispositif (1) pour le traitement thermique d'un objet (2), en particulier d'un substrat revêtu, avec un boîtier (3) pouvant être fermé en particulier de manière étanche aux gaz, qui entoure un espace creux (11), l'espace creux (11) présentant une paroi de séparation (20), au moyen de laquelle l'espace creux (11) est divisé en un espace de processus (21) pour recevoir l'objet (2) et un espace intermédiaire (22), la paroi de séparation (20) présentant une ou plusieurs ouvertures (23, 24), le boîtier(3) présentant au moins une partie de boîtier(9) couplée à un dispositif de refroidissement (14) pour son refroidissement actif, **caractérisé en ce que** la ou les ouvertures sont réalisées de telle sorte que la paroi de séparation (20) agit comme une barrière pour la diffusion hors de l'espace de processus (21) dans l'espace intermédiaire (22) d'une substance gazeuse produite dans l'espace de processus (21) par le traitement thermique de l'objet (2), la paroi de séparation (20) étant disposée entre l'objet (2) et la partie de boîtier(9) pouvant être refroidie.

2. Dispositif (1) selon la revendication 1, dans lequel la paroi de séparation (20) est réalisée de telle sorte qu'une perte de masse de la substance gazeuse lors du traitement thermique est inférieure à 50 %, de préférence inférieure à 20 %, de préférence inférieure à 10 %, dans lequel un rapport de surface, formé à partir d'une surface d'ouverture totale (25) de l'une ou de plusieurs ouvertures (23, 24) divisée par une surface intérieure (26) de l'espace de processus (21), est dans la plage de 5 x 10⁻⁵ à 5 x 10⁻⁴.

3. Dispositif (1) selon l'une des revendications 1 ou 2, dans lequel la paroi de séparation (20) contient un matériau qui présente un coefficient de dilatation thermique tel qu'une surface d'ouverture totale (25) de l'une ou de plusieurs ouvertures (23, 24) est réduite par chauffage de la paroi de séparation (20) pendant le traitement thermique à un maximum de 50 %, de préférence à un maximum de 30 %, plus préférablement à un maximum de 10 %, d'une surface d'ouverture totale (25) avant le traitement thermique.

4. Dispositif (1) selon la revendication 3, **caractérisé en ce que** la paroi de séparation (20) contient un matériau dont le coefficient de dilatation thermique est supérieur à 5 x 10⁻⁶ K⁻¹.

5. Dispositif (1) selon l'une des revendications 1 à 4, dans lequel le boîtier (3) est constitué d'un matériau dont le coefficient de dilatation thermique est inférieur à 5 x 10⁻⁶ K¹, par exemple du verre de quartz.

6. Dispositif (1) selon l'une des revendications 1 à 5, qui comprend un dispositif de chauffage (10) pour chauffer l'espace de processus (21) pour le traitement thermique de l'objet (2) et/ou dans lequel le boîtier (3) comprend au moins une section de boîtier (5, 6), qui est réalisée de telle sorte que l'objet peut être traité thermiquement au moyen d'un rayonnement thermique électromagnétique frappant le boîtier et/ou dans lequel le boîtier (3) présente au moins une section de boîtier (5, 6) couplée à un dispositif de chauffage (12) pour chauffer la chambre de traitement (21).

7. Dispositif (1) selon l'une des revendications 1 à 6, dans lequel la paroi de séparation (20) est disposée entre une zone plus chaude (28) et au moins une zone plus froide (29) de l'espace creux (11).

8. Dispositif (1) selon l'une des revendications 1 à 7, dans lequel la partie de boîtier (9) couplée à un dispositif de refroidissement (14) présente un passage de gaz (16) pouvant être fermé, débouchant dans l'espace intermédiaire (22) pour l'évacuation/alimentation d'au moins une substance gazeuse.

9. Dispositif (1) selon l'une des revendications 1 à 8, dans lequel la section de boîtier (9) couplée à un dispositif de refroidissement (14) est une section de paroi latérale (7) du boîtier (3), qui comprend en particulier un joint (9) pour fermer une ouverture de boîtier (8).

10. Dispositif (1) selon l'une des revendications 1 à 9, dans lequel la paroi de séparation (20) n'atteint pas une paroi du boîtier (6), dans lequel une ouverture, en particulier un espace (23), reste entre la paroi de séparation (20) et la paroi du boîtier (6).

11. Utilisation d'une paroi de séparation (20) dans un boîtier(3) pouvant être fermé en particulier de manière étanche aux gaz dans un dispositif (1) pour le traitement thermique d'un objet (2), le boîtier(3) entourant un espace creux (11), qui est divisé par la paroi de séparation (20) en un espace de processus (21) pour la réception de l'objet (2) et un espace intermédiaire (22), le boîtier(3) présentant au moins une partie de boîtier(9) couplée à un dispositif de refroidissement (14) pour son refroidissement actif, **caractérisé en ce que** la paroi de séparation (20) est disposée entre l'objet (2) et la partie de boîtier (9) pouvant être refroidie et **en ce que** la paroi de séparation (20) présente une ou plusieurs ouvertures (23, 24) qui sont réalisées de telle sorte que la paroi de séparation (20) agit comme une barrière pour la diffusion hors de l'espace de processus (21) dans l'espace intermédiaire (22) d'une substance gazeuse générée dans l'espace de processus (21) par le traitement thermique de l'objet (2).

12. Utilisation selon la revendication 11, dans laquelle la paroi de séparation (20) est réalisée de telle sorte qu'une perte de masse de la substance gazeuse pendant le traitement thermique est inférieure à 50 %, de préférence inférieure à 20 %, de préférence inférieure à 10 %, dans laquelle la paroi de séparation (20) est réalisée de telle sorte qu'un rapport de surface, formé à partir d'une surface d'ouverture totale (25) de l'une ou de plusieurs ouvertures (23, 24) divisée par une surface intérieure (26) de l'espace de processus (21), est dans la plage de 5 x 10⁻⁵ à 5 x 10⁻⁴.

13. Utilisation selon l'une des revendications 11 ou 12, dans laquelle la paroi de séparation (20) présente un coefficient de dilatation thermique tel qu'une surface d'ouverture totale (25) de l'une ou de plusieurs ouvertures (23, 24) est réduite par chauffage de la paroi de séparation pendant le traitement thermique de l'objet (2) à un maximum de 50 %, de préférence à un maximum de 30 %, plus préférablement à un maximum de 10 %, d'une surface d'ouverture totale avant le traitement thermique, dans laquelle la paroi de séparation (20) contient en particulier un matériau ayant un coefficient de dilatation thermique supérieur à 5 x 10⁻⁶ K¹.

14. Procédé de traitement thermique d'un objet (2), en particulier d'un substrat revêtu, comprenant les étapes suivantes:
- Introduction d'un objet dans une cavité (11) d'un boîtier (3) pouvant être fermé en particulier de manière étanche aux gaz, la cavité étant divisée par une paroi de séparation (20), qui présente une ou plusieurs ouvertures (23, 24), en un espace de traitement (21) recevant l'objet et un espace intermédiaire (22),
- Traitement thermique de l'objet (2), dans lequel la paroi de séparation (20) agit comme une barrière pour l'espace de processus de diffusion (21) dans l'espace intermédiaire (22) d'une substance gazeuse générée dans l'espace de processus (21) par le traitement thermique de l'objet (2),
- Refroidissement d'au moins une section de boîtier (9) délimitant l'espace intermédiaire (22) pendant le traitement thermique de l'objet.

15. Procédé selon la revendication 14, dans lequel l'espace de processus (21) est pompé par l'élimination d'au moins une substance gazeuse de l'espace intermédiaire (22) et/ou au moins une substance gazeuse est amenée à l'espace de processus (21) par l'introduction dans l'espace intermédiaire (22).
